# EUROPÄISCHE PATENTSCHRIFT

(11) **EP 1 695 036 B1**
(45) Veröffentlichungstag und Bekanntmachung des Hinweises auf die Patenterteilung: **27.04.2011**
(21) Anmeldenummer: 04803829.3
(22) Anmeldetag: 14.12.2004
(51) Int. Cl.: G01D 5/32, G01D 5/347, H03K 17/968

(54) **LENKSTOCKSCHALTERSYSTEM MIT NOTBETRIEBSFUNKTION**
STEERING COLUMN SWITCH SYSTEM COMPRISING AN EMERGENCY OPERATION FUNCTION
SYSTEME DE COMMUTATEUR SUR COLONNE DE DIRECTION COMPRENANT UNE FONCTION MODE DE SECOURS

(30) Priorität: 16.12.2003 DE 10358838
(43) Veröffentlichungstag der Anmeldung: 30.08.2006
(73) Patentinhaber: Leopold Kostal GmbH & Co. KG, 58507 Lüdenscheid (DE)
(72) Erfinder: BOEHNE, Gregor, 44575 Castrop-Rauxel (DE)
(86) Internationale Anmeldenummer: PCT/EP2004/014201
(87) Internationale Veröffentlichungsnummer: WO 2005/059474

(56) Entgegenhaltungen:
- DE-A1- 19 852 227
- US-A- 5 049 879

## Beschreibung

Die vorliegende Erfindung betrifft ein Lenkstockschaltersystem für ein Kraftfahrzeug, mit einer Einrichtung zur Positionserfassung eines Lenkstockschalterhebels, welche die durch den Lenkstockschalterhebel eingenommene Schaltposition in ein Bitmuster umsetzt, mit einer Dekodierungseinrichtung, welche dem Bitmuster der erkannten Position eine Schaltfunktion zuordnet, und mit einer Einrichtung zur Erkennung von Fehlern bei der Erfassung oder der Übertragung der Bitmuster.

Moderne Lenkstockschaltersysteme schalten nicht direkt den Strom für die anzusteuernden Komponenten wie zum Beispiel Blinkgeber oder Scheibenwischer, sondern ein Microcontroller erfaßt die Position des Lenkstockschalterhebels und gibt Informationen über die aktuelle Schalthebeistellung an verschiedene Steuergeräte weiter. Die erfaßten Positionssignale werden also dekodiert und in für die jeweiligen Steuergeräte geeignete Signale übersetzt.

Aus der deutschen Offenlegungsschrift DE 101 41 975 A1 ist eine Vorrichtung zum optoelektronischen Erfassen von Schaltstellungen eines Schaltmittels bekannt, bei der die Position einer Schaltkulisse durch mehrere optoelektronische Empfänger erfaßt wird.

Durch Kontrollmechanismen (z. B. Strommessungen, Überwachung der Schaltreihenfolgen, Fehlercodes) ist es möglich, Fehler oder Defekte, beispielsweise bewirkt durch die Unterbrechung einer Leiterbahn, zu erkennen.

Es stellte sich die Aufgabe, beim Auftreten von Fehlern innerhalb eines Lenkstockschaltersystems, unter Einbeziehung der Kenntnis über den Defekt, die Dekodierung so zu modifizieren, daß das Lenkstockschaltersystem trotz seines Defekts noch soweit wie möglich funktioniert.

Diese Aufgabe wird erfindungsgemäß dadurch gelöst, daß die Dekodierungseinrichtung bei erkannten Fehlern die Zuordnungen zwischen Bitmustern und auszulösenden Schaltfunktionen ändert.

Ein Ausführungsbeispiel des erfindungsgemäßen Lenkstockschaltersystems ist in der Zeichnung dargestellt und wird im folgenden anhand der Zeichnung näher erläutert.

Es zeigen
Figur 1 eine schematische Darstellung des Grundaufbau eines Lenkstockschaltersystems,
Figur 2 ein Blockschaltbild der zum Lenkstockschaltersystem gehörenden Modulelektronik und die
Figuren 3 bis 5 verschiedenen Lenkstockschalthebelpositionen zugeordnete Bitmuster.

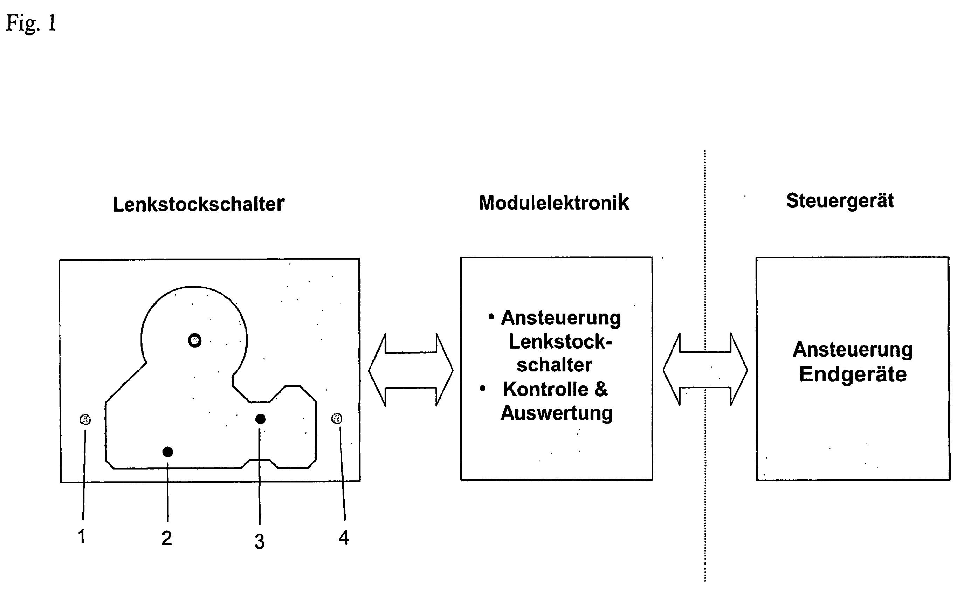

Die Figur 1 verdeutlicht in einer schematischen Darstellung den Aufbau eines Lenkstockschaltersystems. Dunkel unterlegt dargestellt ist die Kontur einer mit einem nicht abgebildeten Lenkstockhebel verbundenen Schaltkulisse. Weiterhin sind die Anbaupositionen von vier Leuchtdioden (1, 2, 3, 4) gezeigt, von denen die mittleren beiden (2, 3) in der dargestellten Lenkstockhebelposition durch die Schaltkulisse verdeckt sind. Das Muster der durch die Schaltkulisse jeweils verdeckten bzw. freigegebenen Leuchtdioden werden durch nicht dargestellte optische Detektoren erfaßt und in ein Bitmuster umgesetzt.

Die in der oberen Hälfte der Schaltkulisse dargestellte dunkle Kreisfläche zeigt die Grundposition des Lenkstockhebels. Weitere mögliche Schalthebelstellungen sind durch Kreisringe angedeutet. Wird der Lenkstockhebel in eine dieser Positionen bewegt, so wird über die Schaltkulisse durch Freigeben bzw. Bedecken von Leuchtdioden ein der jeweiligen Schalthebelposition entsprechendes Bitmuster erzeugt.

Das jeweils vorliegende Bitmuster wird durch eine Modulelektronik erfaßt, welche zu den jeweiligen Bitmustern gehörende Schaltfunktionen durch Ansteuerung von entsprechenden Endgeräten auslöst.

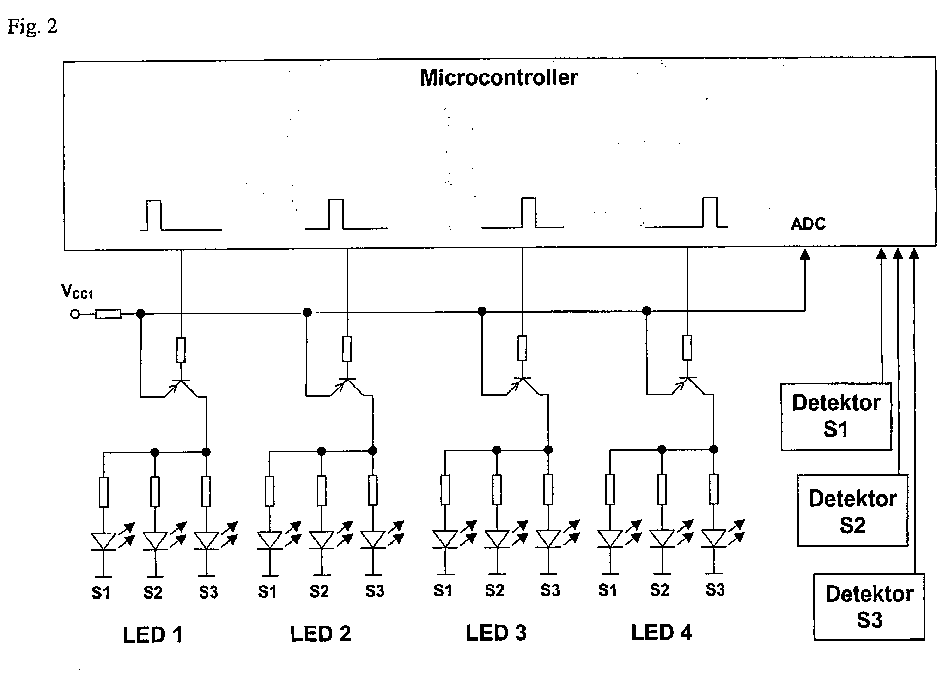

Der Aufbau der in der Figur 1 gezeigten Modulelektronik wird in der Figur 2 verdeutlicht. Herzstück dieser Schaltung ist ein Microcontroller, der aufeinanderfolgend vier LED-Gruppen (LED 1, LED 2, LED 3, LED 4) ansteuert. Jede LED-Gruppe besteht hierbei aus drei parallel angesteuerten Leuchtdioden, wobei die Leuchtdioden aus jeder LED-Gruppe zu verschiedenen Schaltkulissen des Lenkstockschaltersystems gehören. Die dargestellte Anordnung dient somit zur Positionserfassung von drei Lenkstockschaltern S1, S2, S3, etwa von einem Blinkgeberschalter, einem Scheibenwischerschalter und einem Fahrgeschwindigkeitsregler.

Der Microcontroller steuert die LED-Gruppen (LED 1, LED 2, LED 3, LED 4) nacheinander an, wobei ein Analog-Digital-Wandler (ADC) den Stromfluß durch die jeweils angesteuerte LED-Gruppe erfaßt. Durch eine Überwachung des Stromes, der durch die Sende-LEDs des optosensorischen Lenkstockschaltersystem fließt, kann beispielsweise festgestellt werden, wenn eine Zuleitung nach einem Unfall, nach einem Umbau o. ä. unterbrochen ist.

In der dargestellten Realisierung werden die zu jeweils einer LED-Gruppe (LED 1, LED 2, LED 3, LED 4) gehörenden Leuchtdioden der drei Schalter gleichzeitig angesteuert. Es wird nicht jeder LED-Strom einzeln, sondern die Summen der jeweiligen Ströme kontrolliert. Bei einem Defekt liefert also die Stromüberwachung die Information, welche LED-Gruppe betroffen ist, jedoch ist im Allgemeinen zunächst nicht klar, welchem Schalter der Fehler zuzuordnen ist.

Das beschriebene Lenkstockschaltersystem ermöglicht bei erkannten Fehlerzuständen vorteilhafterweise geeignete Reaktionen, die einen möglichst umfangreichen Weiterbetrieb des Systems ermöglichen.

Allerdings sollte aus Sicherheitsgründen bei einem eventuellen Defekt der Fahrgeschwindigkeitsregler nicht in Betrieb bleiben. Die Funktionalitäten des Blinkgeberschalters und des Scheibenwischerschalters werden dagegen soweit wie möglich aufrecht erhalten.

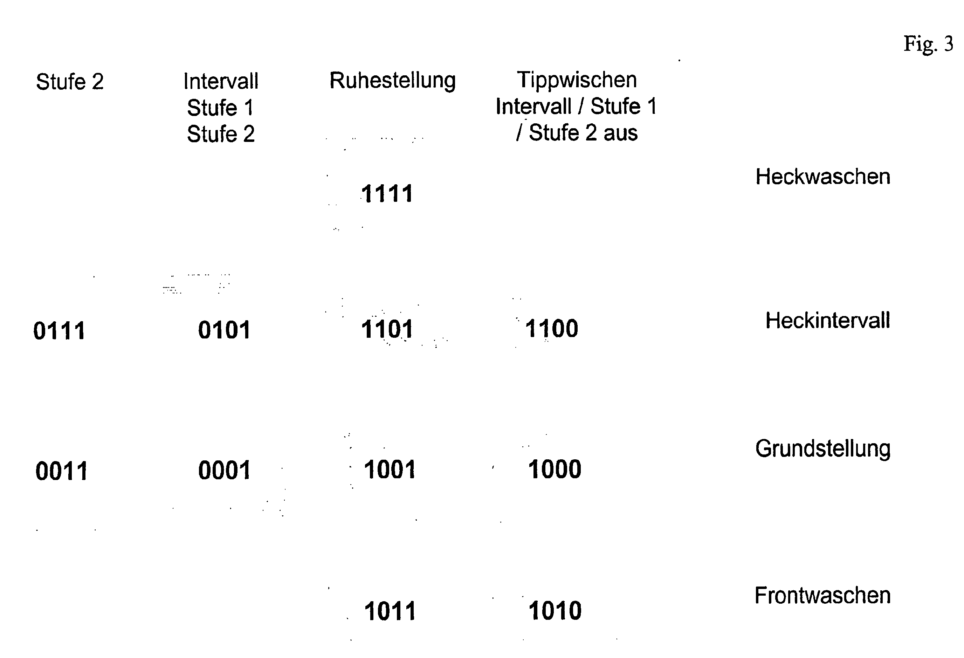

Anhand der Figuren 3 bis 6 ist eine Realisierung beispielhaft anhand eines Scheibenwischerschalters dargestellt.

Die Figur 3 zeigt die den Schaltpositionen der in der Figur 1 dargestellten Schaltkulisse zugehörigen Bitmuster, sowie die zugeordneten Schaltfunktionen bei einem als Scheibenwischerschalter ausgebildeten Lenkstockschalter. Die Grafik gibt die räumliche Anordnung der Codes m it Blick auf die Rastkurve des Lenkstockhebels wieder; eine "0" bzw. "1" bedeutet, daß der durch die Lage der Schaltkulisse beeinflußte Lichtweg von der jeweiligen LED zum Detektor unterbrochen bzw. offen ist. Für die Codierung der Schaltpositionen ist ein Graycode vorgesehen, das heißt nebeneinanderliegende Schaltpositionen unterscheiden sich jeweils durch ein einziges geändertes Bit.

Im Fehlerfall, d. h. bei Ausfall einzelner Leuchtdioden sind geeignete Fehlerreaktionen vorgesehen.

Falls ein zu geringer LED 2- oder ein zu geringer LED 3-Summenstrom gemessen wird, wird der Scheibenwischerschalter in Betrieb gehalten, wobei Funktionen, die durch die zweite bzw. dritte LED signalisiert werden, also bei denen das zweite bzw. dritte Bit gesetzt ist, nicht mehr ausgeführt werden können.

Aus der Figur 3 lassen sich folgende Funktionseinschränkungen ablesen:
- Falls LED 2 des Scheibenwischerschalter ausfällt: Alle Heckfunktionen funktionieren nicht.
- Falls LED 3 des Scheibenwischerschalter ausfällt: Die Waschfunktionen und die direkte Aktivierung von Wischen 2 funktionieren nicht.

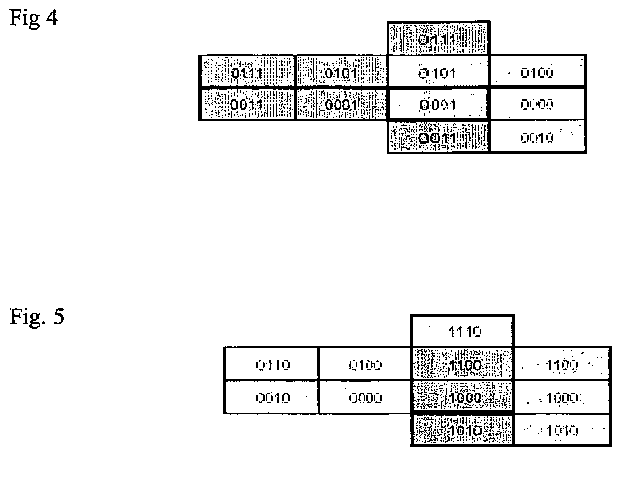

Wird LED 1 oder LED 4 als defekt erkannt, so wird ein Notbetrieb des Scheibenwischerschalters eingeleitet. Hierzu werden die detektierten Codes mit geänderten Schaltfunktionen verknüpft. In den Figuren 3 und 4 sind Positionen mit geänderter Funktionalität mit hellen bzw. dunkel hinterlegten Feldern dargestellt. Die hell unterlegten Felder kennzeichnen dabei Bitmuster, die bei einem ungestörten System nicht vorkommen.

Die Figur 4 zeigt die durch die Modulelektronik erkannten Bitmuster bei einem Fehler der LED 1. Falls ein zu geringer LED 1-Strom gemessen wird, wird in der Ruhestellung des Lenkstockschalters der Code für "Intervall, Wischen 1,2" (0001) detektiert. Die Funktionen Front- und Heckwaschen funktionieren nicht. Wenn der Fahrer versucht, den Scheibenwischer auszuschalten, wird ein Fehler erkannt. Daraufhin wird ein Notbetrieb mit den nachfolgenden Schaltfunktionszuordnungen aufgenommen:

| | |
|---|---|
| 0000 | Tippwischen, Intervall 1,2 aus |
| 0001 | Ruhestellung |
| 0010 | Frontwaschen und Tippwischen |
| 0011 | Tippwischen, Intervall 1,2 |
| 0100 | Tippwischen, Intervall 1,2 aus in Heckintervall |
| 0101 | Heckintervall |
| 0111 | Tippwischen, Intervall 1,2 in Heckintervall |

In diesem Notbetrieb funktioniert also Heckwaschen und die direkte Aktivierung der Funktion Wischen 2 nicht, sowie Frontwaschen nur in Kombination mit Tippwischen. Wenn der Fahrer den Scheibenwischer aktivieren will, werden die Funktionen zu spät, aber prinzipiell richtig aktiviert.

Vergleicht man die sich bei ausgefallener LED 4 ergebenen Bitmuster, dargestellt in der Figur 5, mit der ungestörten Bitmusterzuordnung der Figur 3, so ergibt sich, daß in diesem Fehlerfall eine der Tippwisch-Funktionen ausgelöst wird, solange der Schalter in Ruhestellung / Heckintervall / Frontwaschen steht. Wenn der Fahrer "herumrührt", wird der Schalter eine der hell gekennzeichneten Positionen annehmen, welche Bitmuster aufweisen, die bei einem fehlerfreien System nicht vorkommen, so daß daraufhin ein Notbetrieb aktiviert werden kann.

Der Notbetrieb für diesen Fehler kann die folgende Zuordnung zwischen Bitmuster und Schaltfunktionen vorsehen:

| | |
|---|---|
| 0000 | Tippwischen |
| 0010 | Wischen 2 einschalten / Wischen 2 ausschalten |
| 0100 | Tippwischen im Heckintervall |
| 0110 | Wischen 2 einschalten / Wischen 2 ausschalten im Heckintervall |
| 1000 | Ruhestellung |
| 1100 | Heckintervall |
| 1010 | Frontwaschen |
| 1110 | Heckwaschen |

Bei den optosensorischen Lenkstockschaltersystem ist es damit möglich, Defekte zu erkennen und bei nicht vollständig defekten Schaltern eine Restfunktionalität aufrechtzuerhalten, indem, je nach Defekt, entweder der Schalter unverändert weiter betrieben wird oder eine Notbetrieb-Dekodieru ng aktiviert wird. Eine entsprechende Neubelegung bei erkannten fehlerhaften Sensorfunktionen kann entsprechend auch für den Blinkgeberschalter vorgesehen werden, wobei lediglich darauf zu achten ist, daß die Neubelegung der Schalter möglichst mit durch den Fahrer intuitiv erwarteten Funktionen erfolgt, also daß der Fahrer durch die Neubelegung nicht durch unerwartete Funktionen übermäßig überrascht wird.

Aus diesem Grund sollte auch ein über Lenkstockschalter gesteuerter Fahrgeschwindigkeitsregler bei einem möglichen Defekt vollständig deaktiviert werden.

Die Erkennung eines Fehlers kann eine entsprechende Fehlermeldung des Microcontroller auslösen, so daß der Fahrer z.B. über ein Display auf den Fehler hingewiesen wird und zum Aufsuchen einer Werkstatt veranlasst wird.

## Patentansprüche

1. Lenkstockschaltersystem für ein Kraftfahrzeug,
mit einer Einrichtung zur Positionserfassung des Lenkstockschaltersystems, welche die durch den Lenkstockschalterhebel eingenommene Schaltposition in ein Bitmuster umsetzt,
mit einer Dekodierungseinrichtung, welche dem Bitmuster der erkannten Position eine Schaltfunktion zuordnet,
und mit einer Einrichtung zur Erkennung von Fehlern bei der Erfassung oder der Übertragung der Bitmuster,
**dadurch gekennzeichnet,**
**daß** die Dekodierungseinrichtung dazu ausgelegt ist, bei erkannten Fehlern die Zuordnungen zwischen Bitmustern und auszulösenden Schaltfunktionen zu ändern.

2. Lenkstockschaltersystem nach Anspruch 1, **dadurch gekennzeichnet, daß** die Dekodierungseinrichtung dazu ausgelegt ist, bei erkannten Fehlern die Zuordnungen zwischen Bitmustern und auszulösenden Schaltfunktionen abhängig vom erkannten Fehler zu ändern.

3. Lenkstockschaltersystem nach Anspruch 1 oder 2, **dadurch gekennzeichnet, daß** die Dekodierungseinrichtung dazu ausgelegt ist, im Fehlerfall die vorgegebenen einzelnen Schaltpositionen zugeordnete Schaltfunktionen zu deaktivieren.

4. Lenkstockschaltersystem nach Anspruch 1 oder 2, **dadurch gekennzeichnet, daß** die Dekodierungseinrichtung dazu ausgelegt ist, im Fehlerfall vorgegebenen einzelnen Schaltpositionen vom Normalbetrieb abweichende Schaltfunktionen zu zuordnen.

5. Lenkstockschaltersystem nach Anspruch 1, **dadurch gekennzeichnet, daß** die Einrichtung zur Positionserfassung dazu ausgelegt ist, die jeweilige Schaltposition mittels einer Schalteinrichtung zu erfassen, die mehrere mechanische Schaltkontakte aufweist.

6. Lenkstockschaltersystem nach Anspruch 1, **dadurch gekennzeichnet, daß** die Einrichtung zur Positionserfassung dazu ausgelegt ist, die jeweilige Schaltposition mittels berührungsloser Sensoren zu erfassen.

7. Lenkstockschaltersystem nach Anspruch 6, **dadurch gekennzeichnet, daß** die Einrichtung zur Positionserfassung dazu ausgelegt ist, die jeweilige Schaltposition mittels magnetempfindlicher Sensoren zu erfassen.

8. Lenkstockschaltersystem nach Anspruch 6, **dadurch gekennzeichnet, daß** die Einrichtung zur Positionserfassung dazu ausgelegt ist, die jeweilige Schaltposition mittels optischer Sensoren zu erfassen.

9. Lenkstockschaltersystem nach Anspruch 8, **dadurch gekennzeichnet, daß** das der jeweiligen Schaltposition zugeordnete Bitmuster als serielles Signal durch zyklisches Abfragen der Zustände mehrerer Lichtschranken erfaßt wird.

10. Lenkstockschaltersystem nach Anspruch 1, **dadurch gekennzeichnet, daß** die Dekodierungseinrichtung einen Microcontroller umfaßt, welcher die Zuordnung zwischen erfaßter Schaltposition und auszulösender Schaltfunktion mittels einer in Speichermitteln abgelegten Zuordnungsliste oder Zuordnungstabelle vornimmt.

11. Lenkstockschaltersystem nach Anspruch 10, **dadurch gekennzeichnet, daß** im Falle eines erkannten Fehlers die Dekodierungseinrichtung dazu ausgelegt ist, die verwendete Zuordnungsliste oder Zuordnungstabelle fehlerspezifisch abzuaändern oder die Zuordnung aufgrund einer alternativen, in Speichermitteln abgelegten fehlerspezifischen Zuordnungsliste oder Zuordnungstabelle vor zu nehmen.

12. Lenkstockschaltersystem nach Anspruch 1, **dadurch gekennzeichnet, daß** die Bitkodierung nebeneinander liegender Schaltpositionen mittels eines Graycodes erfolgt.

## Claims

1. Steering column switch system for a motor vehicle,
having a device for detecting the position of the steering column switch system which translates the switch position assumed by the steering column switch lever into a bit pattern,
having a decoding facility which assigns a switching function to the bit pattern of the identified position,
and having a device for identifying faults in the detection or transmission of the bit patterns,
**characterised in that**
the decoding facility is designed for the purpose of changing the assignments between bit patterns and switching functions to be triggered in the event of identified faults.

2. Steering column switch system in accordance with Claim 1, **characterised in that** the decoding facility is designed for the purpose of changing the assignments between bit patterns and switching functions to be triggered in the event of identified faults in dependence on the identified fault.

3. Steering column switch system in accordance with Claim 1 or Claim 2, **characterised in that** the decoding facility is designed for the purpose of deactivating switching functions assigned to specific individual switch positions in the event of a fault.

4. Steering column switch system in accordance with Claim 1 or Claim 2, **characterised in that** the decoding facility is designed for the purpose of assigning switching functions that deviate from normal operation to specific individual switch positions in the event of a fault.

5. Steering column switch system in accordance with Claim 1, **characterised in that**, for position-detection purposes, the device is designed for the purpose of detecting the respective switch position by means of a switching device featuring several mechanical switch contacts.

6. Steering column switch system in accordance with Claim 1, **characterised in that**, for position-detection purposes, the device is designed for the purpose of detecting the respective switch position by means of noncontact sensors.

7. Steering column switch system in accordance with Claim 6, **characterised in that**, for position-detection purposes, the device is designed for the purpose of detecting the respective switch position by means of magnet-sensitive sensors.

8. Steering column switch system in accordance with Claim 6, **characterised in that** for position-detection purposes the device is designed for the purpose of detecting the respective switch position by means of optical sensors.

9. Steering column switch system in accordance with Claim 8, **characterised in that** the bit pattern assigned to the respective switch position is detected as a serial signal by means of cyclically scanning the states of several light barriers.

10. Steering column switch system in accordance with Claim 1, **characterised in that** the decoding facility comprises a microcontroller which undertakes the assignment between the detected switch position and the switching function to be triggered by means of an assignment map or assignment table filed in the storage means.

11. Steering column switch system in accordance with Claim 10, **characterised in that** in the event of an identified fault, the decoding facility is designed for the purpose of amending the utilised assignment map or assignment table according to the specific fault or to undertake the assignment on the basis of an alternative fault-specific assignment map or assignment table filed in the storage means.

12. Steering column switch system in accordance with Claim 1, **characterised in that** the bit coding of switch positions lying adjacent to each other takes place by means of a Gray code.

## Revendications

1. Système commutateur de colonne de direction pour un véhicule automobile, avec un dispositif pour la détection de la position du système de commutation de colonne de direction, qui convertit en une séquence binaire la position de commutation prise par le levier de commutation, avec un dispositif de décodage, qui associe une fonction de commutation à la séquence binaire de la position détectée, et avec un dispositif pour la détection d'erreurs lors de la saisie ou de la transmission de la séquence binaire, **caractérisé en ce que** le dispositif de décodage est prévu pour modifier, lors de la détection d'une erreur, les associations entre des séquences binaires et les fonctions de commutation à déclencher.

2. Système commutateur de colonne de direction selon la revendication 1, **caractérisé en ce que** le dispositif de décodage est prévu pour modifier, en fonction des erreurs détectées, les associations entre des séquences binaires et les fonctions de commutation à déclencher.

3. Système commutateur de colonne de direction selon revendication 1 ou 2, **caractérisé en ce que** le dispositif de décodage est prévu pour désactiver, en cas d'erreur, les fonctions de commutation associées à des positions de commutation individuelles, prédéterminées.

4. Système commutateur de colonne de direction selon revendication 1 ou 2, **caractérisé en ce que** le dispositif de décodage est prévu pour associer, en cas d'erreur, des fonctions de commutation divergeant du fonctionnement normal à des positions de commutation individuelles, prédéterminées.

5. Système commutateur de colonne de direction selon la revendication 1, **caractérisé en ce que** le dispositif de détection de position est destiné à détecter chaque position de commutation au moyen d'un dispositif de commutation, qui présente plusieurs contacts de commutation mécaniques.

6. Système commutateur de colonne de direction selon la revendication 1, **caractérisé en ce que** le dispositif de détection de position est destiné à détecter chaque position de commutation au moyen de détecteurs sans contact.

7. Système commutateur de colonne de direction selon la revendication 6, **caractérisé en ce que** le dispositif de détection de position est destiné à détecter chaque position de commutation au moyen de détecteurs sensibles au magnétisme.

8. Système commutateur de colonne de direction selon la revendication 6, **caractérisé en ce que** le dispositif de détection de position est destiné à détecter chaque position de commutation au moyen de détecteurs optiques.

9. Système commutateur de colonne de direction selon la revendication 8, **caractérisé en ce que** la séquence binaire, associée à chaque position est détectée en tant que signal sériel par interrogation cyclique des états de plusieurs barrières lumineuses.

10. Système commutateur de colonne de direction selon la revendication 1, **caractérisé en ce que** le dispositif de décodage comprend un microcontrôleur, qui procède à l'association entre la position de commutation détectée et la fonction de commutation à déclencher au moyen d'une liste d'association ou d'une table d'association, qui est enregistrée dans un dispositif de mémorisation.

11. Système commutateur de colonne de direction selon la revendication 10, **caractérisé en ce que** le dispositif de décodage est prévu pour modifier, lors de la détection d'une erreur, la liste d'association ou la table d'association de manière spécifique aux erreurs, ou de procéder à l'association sur la base d'une liste d'association ou d'une table d'association spécifiques aux erreurs, enregistrée dans le dispositif de mémorisation.

12. Système de commutateur pour colonne de direction selon la revendication 1, **caractérisé en ce que** le codage binaire des positions voisines est effectué au moyen d'un code binaire cyclique (Gray).
